Europäisches Patentamt

European Patent Office

Office européen des brevets

(19)

(11) Publication number: **0 204 473**
**A2**

(12) # EUROPEAN PATENT APPLICATION

(21) Application number: **86303936.8**

(22) Date of filing: **23.05.86**

(51) Int. Cl.⁴: **G 01 R 29/08**
**G 01 J 5/34**

(30) Priority: **01.06.85 GB 8513843**

(43) Date of publication of application:
**10.12.86 Bulletin 86/50**

(84) Designated Contracting States:
**BE DE FR IT NL SE**

(71) Applicant: **GEC AVIONICS LIMITED**
**Airport Works**
**Rochester Kent ME1 2XX(GB)**

(72) Inventor: **Benson, Frank Atkinson**
**64 Grove Road**
**Sheffield, S7 2GZ(GB)**

(72) Inventor: **Anderson, Alan Patrick**
**12, Meadowbank Avenue**
**Sheffield, S7 1PB(GB)**

(72) Inventor: **Lee, Timothy Martin**
**281 Hollinsend Road**
**Sheffield, S12 2NJ(GB)**

(74) Representative: **Rouse, David George et al,**
**General Electric Company p.l.c. Central Patent Dept.**
**(Chelmsford Office) Marconi Research Centre West**
**Hanningfield Road**
**Great Baddow Chelmsford Essex CM2 8HN(GB)**

(54) **Improvements in or relating to microwave energy detection.**

(57) A microwave imaging arrangement is provided which consists of a sheet of pyroelectric plastics material (e.g. PVDF) carrying on one surface an array of individual elemental conductors. The individual elemental conductors are excited by different parts of an incident microwave beam to produce individual electrical signals of a level dependent upon the spatial modulation of the incident beam. To the rear of said sheet of pyroelectric plastics material is provided a ground plane member spaced by approximately λ/4 where λ is the wavelength of the incident microwave beam. Normally the distance separating the ground plane member from the rear of the sheet of pyroelectric plastics material is adjustable.

*FIG. 1.*

EP 0 204 473 A2

Improvements in or Relating to
Microwave Energy Detection

This invention relates to microwave energy detection and in particular to imaging microwave energy detecting arrangements.

As is known, it is possible to propagate a beam of microwave energy which is spatially modulated, that is to say the beam is of different energy levels at different parts in cross section. By this means, for example, pictures may be transmitted from a microwave transmitter to a microwave receiver.

The present invention seeks to provide an improved microwave energy detector and in particular an improved microwave energy imaging arrangement.

According to this invention a microwave energy detecting arrangement comprises a sheet of pyroelectric material carrying on one surface thereof presentable to a microwave energy beam, at least one elemental conductor provided to be excited by said microwave energy to produce a temperature increase which is transmitted to said pyroelectric material whereby to produce an electrical signal, and means for taking off said electrical signal from said elemental conductor.

In order to provide an imaging function preferably a plurality of spaced elemental conductors are provided across the surface of said pyroelectric material.

Preferably means are provided for taking electrical output signals individually from each said elemental conductors.

Preferably said plurality of elemental conductors are arranged in a regular matrix of rows and columns.

Preferably said pyroelectric material is a pyroelectric plastics material.

Preferably said pyroelectric plastics material is PVDF, but other materials may be used.

Preferably each elemental conductor is of a cruciform shape.

Each elemental conductor may be of aluminium and may be coated with a conductive material such as carbon in order to achieve good matching with free space.

Preferably said detecting element comprising said sheet of pyroelectric material is mounted facing an incident beam of microwave energy with a ground plane member to its rear. The distance separating said detecting element from the aforementioned ground plane member is preferably adjustable and preferably of the order of $\lambda/4$ where $\lambda$ is the wavelength of said incident microwave energy.

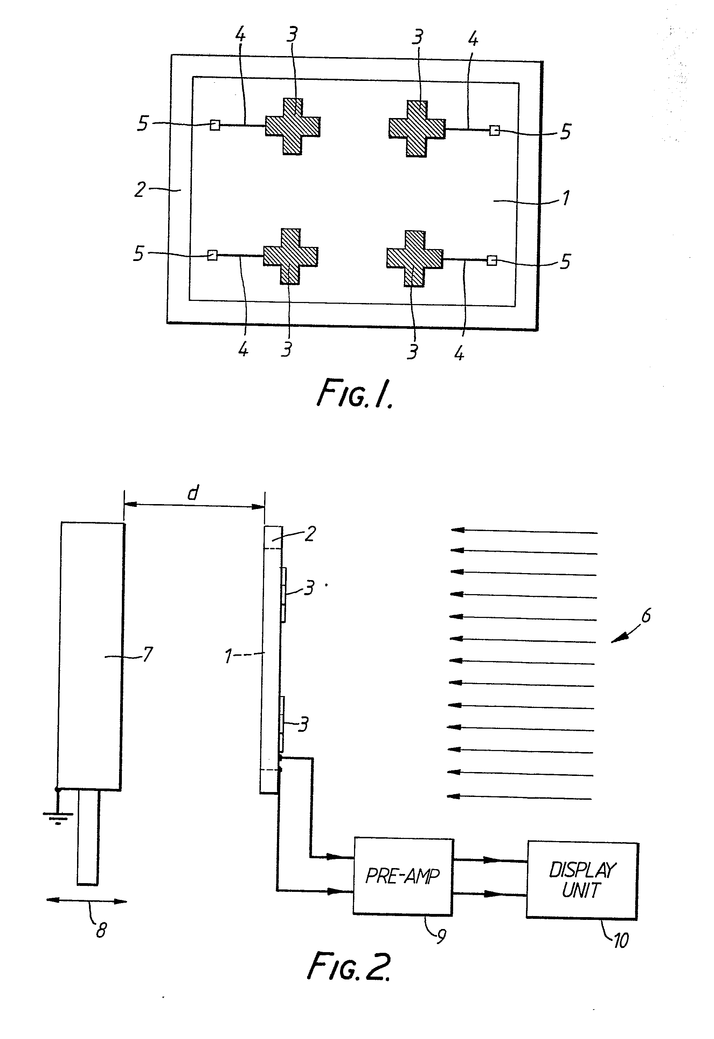

The invention is further described with reference to the accompanying drawing in which Figure 1 is a face view of a microwave detecting element in accordance with the present invention and Figure 2 schematically illustrates an arrangement incorporating the element of Figure 1.

Referring to Figure 1 the detecting element consists of a sheet 1 of pyroelectric plastics material (in this case PVDF) which is mounted within an electrically conductive frame 2. Deposited on one side of the sheet 1 is an array of elemental conductors 3 each, in this example, having a cruciform shape and being of aluminium. Each elemental conductor 3 has connected thereto a deposited stripline conductor 4 extending to a connecting pad 5 located towards the edge of the sheet 1, adjacent the frame 2. The conductive strip line conductors 4 and connecting pads 5 are of gold.

If the detecting element shown in Figure 1 is exposed to incident microwave energy (for example at a frequency of 7.5GHz) each elemental conductor 3 will be excited by the microwave energy falling upon it, its temperature will rise and due to the action of the pyroelectric material of a sheet 1 an electrical signal will be generated.  The strength of the signal generated at each elemental conductor 3 will be dependent _inter_ _alia_ upon the level of the microwave energy incident upon that element.  Thus, if the incident beam of microwave energy is spatially modulated so that different parts of the beam in cross-section are of different energy levels, the elemental conductors 3 will each respond differently to produce different voltage levels at each of their output connecting pads 5.  Overall therefore the effect is to translate the "image" transmitted by the microwave beam by virtue of the different energy levels exhibited in cross-section, into an electrical image.

Referring to Figure 2 the detector element of Figure 1 is shown mounted in the path of a spatially modulated microwave beam, represented by the arrows 6. Mounted a distance d to the rear of the detector element is a ground plane member 7.  The distance d is approximately $\lambda/4$ i.e. one quarter of the wavelength of the incident microwave energy 6.  The ground plane member 7 is adjustable in position (as represented by the double headed arrow 8) so as to adjust the distance d for maximum effect.  Each of the output connecting pads 5 of the different elemental conductors 3 is connected, after suitable amplification in a pre-amplifying arrangement 9, to a display unit 10. The nature of the display unit 10 will not be described in detail but may take any convenient form.  For example it may comprise a matrix of electro-optic devices, each corresponding to a different one of the elemental conductors 3 and energised by signals derived from that elemental conductor, or it may include a scanning arrangement to produce a TV-type signal.

4

The overall result will be to produce a visible picture at the display unit 10 which corresponds to the microwave image transmitted by modulations of energy levels across the microwave beam incident upon the detecting element.

Whilst for ease of illustration but four elemental conductors 3 are shown, in practice of course many more would be used to form the matrix. Up to a point, the greater the number of elemental conductors 3 the better will be the resolution obtained, but if the distances separating the elemental conductors 3 are reduced to too great an extent, some "cross talk" may be apparent with the heating effect of one elemental conductor contributing to the electrical signal picked up by another.

It will also be appreciated that the shape and dimensions of the elemental conductors will have an effect upon the response obtained. Amongst the factors to be taken into account are of course the extent to which each element is excited by the incident microwave energy and the transference of the heat thus generated into the pyroelectric material of the sheet 1. At present the cruciform nature illustrated is preferred, but other shapes and patterns may be used. At present the shapes and dimensions of the elemental conductors 3, the number of elemental conductors employed in the matrix and hence the separation of one elemental conductor from another, are factors best determined empirically.

Whilst in the embodiment illustrated the elemental conductors are of aluminium, other materials may be suitable. The elemental conductors 3 may also be provided with surface coatings, for example of carbon, to improve the match of the elemental conductors with free space. The thickness of the carbon coatings may of course be varied in order to optimise matching.

Whilst in the embodiment illustrated the ground plane 7 is of metal (e.g. copper), in other embodiments a dielectric ground plane member may be used.

CLAIMS

1.   A microwave energy detecting arrangement comprising a sheet of pyroelectric material carrying on one surface thereof presentable to a microwave energy beam, at least one elemental conductor provided to be excited by said microwave energy to produce a temperature increase which is transmitted to said pyroelectric material whereby to produce an electrical signal, and means for taking off said electrical signal from said elemental conductor.

2.   An arrangement as claimed in claim 1 and wherein, in order to provide an imaging function, a plurality of spaced elemental conductors are provided across the surface of said pyroelectric material.

3.   An arrangement as claimed in claim 2 and wherein means are provided for taking electrical output signals individually from each of said elemental conductors.

4.   An arrangement as claimed in claim 2 or 3 and wherein said plurality of elemental conductors are arranged in a regular matrix of rows and columns.

5.   An arrangement as claimed in any of the above claims and wherein said pyroelectric material is a pyroelectric plastics material.

6.   An arrangement as claimed in claim 5 and wherein said pyroelectric plastics material is PVDF.

7.   An arrangement as claimed in any of the above claims 2 to 6 and wherein each elemental conductor is of a cruciform shape.

8.   An arrangement as claimed in any of the above claims and wherein each elemental conductor is of aluminium.

9.   An arrangement as claimed in any of the above claims and wherein each elemental conductor is coated with a conductive material such as carbon in order to achieve good matching with free space.

10. An arrangement as claimed in any of the above claims and wherein said detecting element comprising said sheet of pyroelectric material is mounted facing an incident beam of microwave energy with a ground plane member to its rear.

11. An arrangement as claimed in claim 10 and wherein the distance separating said detecting element from said ground plane member is adjustable.

12. An arrangement as claimed in claim 10 or 11 and wherein the distance separating said detecting element from said ground plane member is of the order of $\lambda/4$ where $\lambda$ is the wavelength of said incident microwave energy.

0204473

1/1

**FIG. 1.**

**FIG. 2.**

PRE-AMP

DISPLAY UNIT